Europäisches Patentamt

European Patent Office

Office européen des brevets

(11) Publication number: **0 436 134 A2**

## (12) EUROPEAN PATENT APPLICATION

(21) Application number: **90123245.4**

(22) Date of filing: **04.12.90**

(30) Priority: **19.12.89 JP 327221/89**

(43) Date of publication of application:
**10.07.91 Bulletin 91/28**

(84) Designated Contracting States:
**DE FR GB**

(51) Int. Cl.⁵: **G06K 19/06, H05K 3/30**

(71) Applicant: **Kabushiki Kaisha Toshiba**
**72, Horikawa-cho Saiwai-ku**
**Kawasaki-shi(JP)**

(72) Inventor: **Nakamura, Koichiro, c/o Intellectual**
**Property Div.**
**K.K. Toshiba, 1-1 Shibaura 1-chome,**
**Minato-ku**
**Tokyo 105(JP)**

(74) Representative: **Blumbach Weser Bergen**
**Kramer Zwirner Hoffmann Patentanwälte**
**Radeckestrasse 43**
**W-8000 München 60(DE)**

㊾ **IC card.**

(57) In an IC card, a gap (29) is formed between a terminal (27) and the circumference of a mounting hole (25) formed in a printed circuit board (11). Even if the printed circuit board (11) is deformed, large stress is prevented from being transmitted to the terminal (29), due to the formation of the gap (29).

F I G. 6

## IC CARD

The present invention relates to an IC card which incorporates a CPU, a data memory, etc., and which is used solely as an electronic calculator, a timepiece, a cash card or the like or used in combination with a terminal device.

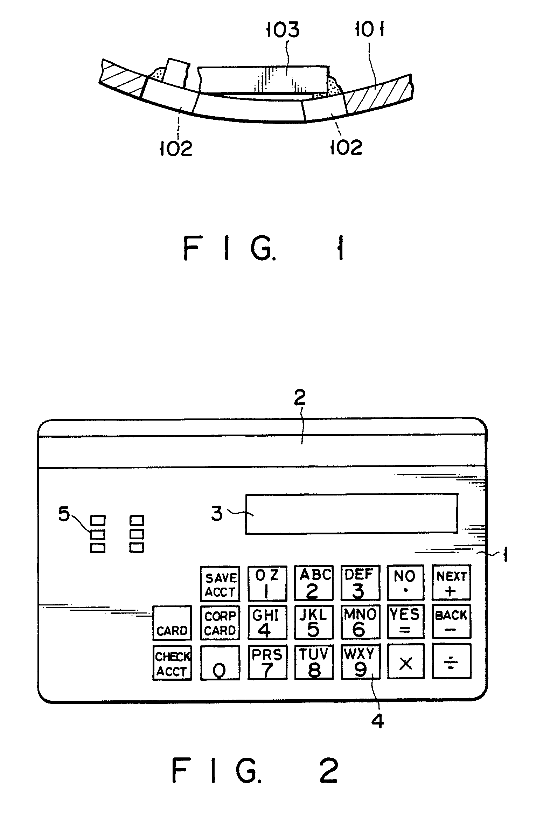

As is shown in Fig. 1, an IC card incorporates a printed circuit board 101. An electronic component, such as an integrated circuit element, a capacitor, a quartz oscillator, or the like is electrically connected to the printed circuit board 101 by way of terminals 102.

In a conventional IC card, one end of a terminal 102 is connected to the printed circuit board 101 by utilization of the overall width thereof. Therefore, if the printed circuit board 101 is curved or deformed due to a high temperature, the strain is transmitted from the printed circuit board 101 to the electronic component through the terminal 102. As a result, it is likely that the electronic component 103 will be disconnected from the terminal 102 of the printed circuit board 101 or will be broken.

Accordingly, an object of the present invention is to provide an IC card which prevents an electronic component from being disconnected from the terminal of a printed circuit board or from being damaged even if the printed circuit board is curved or thermally deformed.

To achieve this object, the present invention provides an IC card which comprises: a printed circuit substrate, having a cavity for receiving the electronic component therein; and a terminal means, projected into the cavity, for connecting the electronic component and the printed circuit substrate.

The present invention also comprises an IC card which comprises: substrate means for incorporating the electronic component, supporting means projected from the substrate means, for supporting the electronic component there on; and a connecting means for connecting the supporting means and the electronic component.

This invention can be more fully understood from the following detailed description when taken in conjunction with the accompanying drawings, in which:

Fig. 1 is an explanatory view of a conventional IC card;
Fig. 2 is a plan view of an IC card according to one embodiment of the present invention;
Fig. 3 is a perspective exploded view of the IC card shown in Fig. 2;
Fig. 4 is a partly-cutaway plan view showing the internal structure of the IC card shown in Fig. 2;
Fig. 5 is a schematic view illustrating how an electronic component is connected to a terminal of the printed circuit board of the IC card shown in Fig. 2;
Fig. 6 is a sectional view taken along line IV-IV in Fig. 5;
Fig. 7 is a schematic view illustrating how an electronic component is connected to a terminal of the printed circuit board of an IC card according to another embodiment of the present invention; and
Fig. 8 is a sectional view taken along line VII-VII in Fig. 8.

An IC card of the present invention will now be described, referring to the first embodiment shown in Figs. 2-6.

Fig. 2 is a plan view of the IC card. In Fig. 2, reference numeral 1 denotes a back panel. This back panel 1 comprises a magnetic stripe 2, a display window 3, a keyboard 4, and holes 5 which allow contacts 21 (to be mentioned later) to be projected therefrom.

The magnetic stripe 2 stores information regarding a given individual person, transaction data, etc.

On the display window 3, the deposited amount in a back, the term of validity, the past transaction data, etc. are displayed in response to the operation of the keyboard 4.

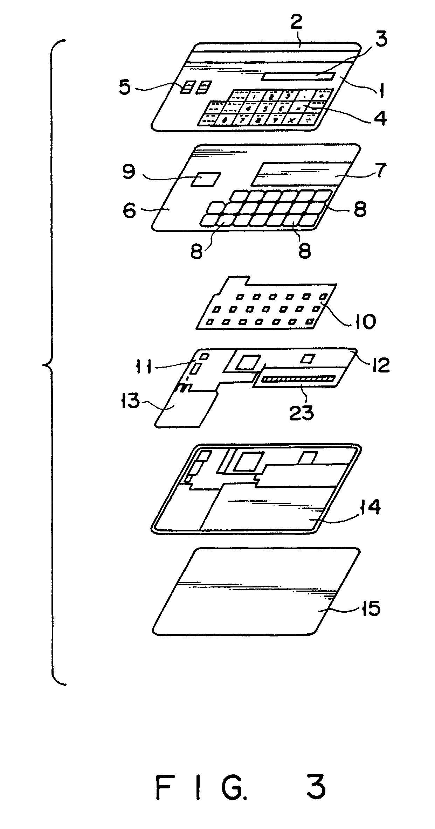

Reference numeral 6 in Fig. 3 denotes a spacer. This spacer 6 comprises an opening 7 formed in correspondence to the display window 3 mentioned above. It also comprises a large number of holes 8 into which the respective keys of the keyboard 4 are fitted, and a hole section 9 formed in correspondence to the holes 5 of the back panel 1.

Reference numeral 10 in Fig. 3 denotes a membrane switch which is turned on or off in response to the operation of the keyboard 4.

Reference numeral 11 in Fig. 3 denotes a flexible printed circuit board (FPC). A film 12 having a circuit pattern thereon, and a battery 13 are connected to the flexible printed circuit board 11. The membrane switch 10 mentioned above and a liquid crystal display 23 are also connected to the film 12. The liquid crystal display 23 is located in correspondence to the display window 3.

Reference numeral 14 in Fig. 3 denotes a plastic dam formed by injection molding and constituting the outer peripheral portions of the IC card.

Reference numeral 15 in Fig. 3 is a front panel.

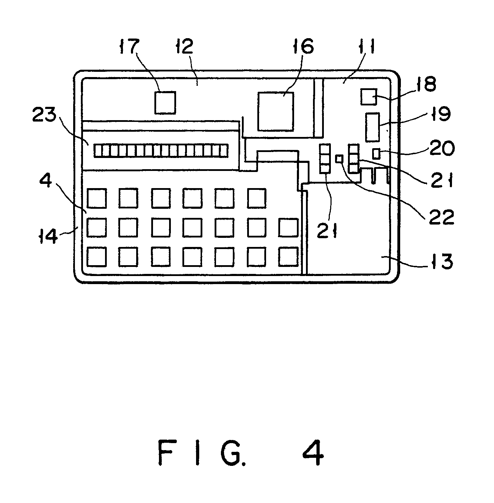

As is seen from the internal structure shown in Fig. 4, a CPU 16 and a driver 17 for driving the liquid crystal display 23 are electrically connected to the circuit pattern of the film 12 by fusion bonding. Electronic components, such as a capacitor network 18, a quartz oscillator 19 and a chip capacitor 20. are arranged on the printed circuit board 11. Further, contacts 21 and a static electricity-withstanding element 22 are arranged on the printed circuit board 11.

The contacts 21 are fitted in both the hole section 9 of the spacer 6 and the holes 5 of the back panel 1, and are projected from the back panel 1. When the IC card is inserted into an external device, such as a terminal device of a computer system, the contacts 21 touch the contacts terminals of the external device.

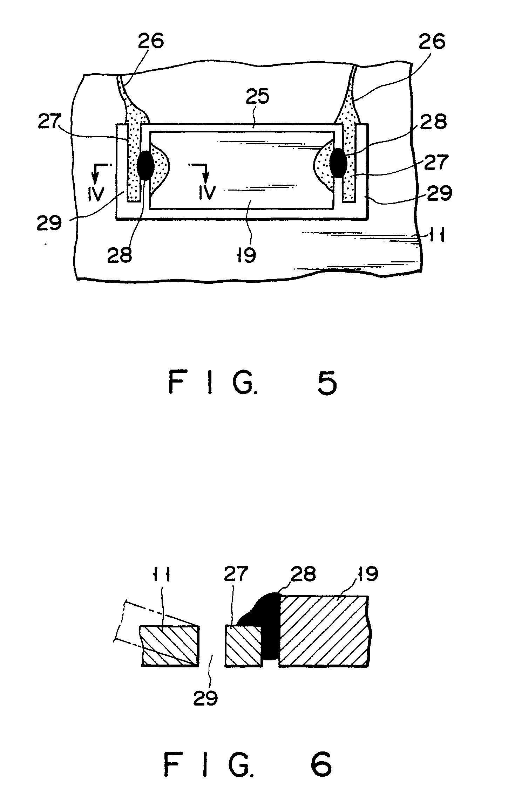

As is shown in Fig. 5, the printed circuit board 11 has a quadrilateral mounting hole 25 (i.e., an opening), and the quartz oscillator 19 is mounted inside the mounting hole 25. Wiring patterns 26 are formed on the surface of the printed circuit board 11, and the quartz oscillator 19 electrically connected to the wiring patterns 26 through terminals 27. The quartz oscillator 19 and the terminals 27 are secured to each other by use of solder 28 (i.e., a connecting member).

One end of each terminal 27 is connected to the corresponding wiring pattern 26 formed on the printed circuit board 11. One side portion of each terminal 27 is arranged in parallel to, and spaced away from the inner periphery of the mounting hole 25 of the printed circuit board 11, such that a certain gap or space 29 is defined. The printed circuit board 11 and the terminals 27 are integrally formed by a flexible plate.

When the IC card is used or carried, it may be curved or its temperature may increase. In such a case, the printed circuit board 11 of the IC card is deformed in such a manner as is indicated by the broken lines in Fig. 6. However, since the space 29 is defined between the periphery of the mounting hole 25 and the one-side portion of each terminal 27, large stress is not transmitted to each terminal 27. Therefore, the quartz oscillator 19 is reliably prevented from being disconnected from the terminals 27 and from being broken or damaged.

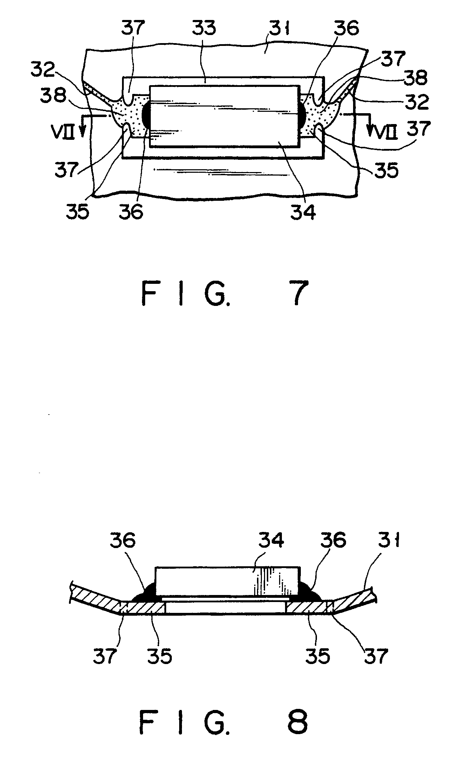

Fig. 7 shows another embodiment of the present invention.

Referring to Fig. 7, reference numeral 31 denotes a printed circuit board, on which wiring patterns 32 are formed. A mounting hole 33 is formed in the printed circuit board 31, and a quartz oscillator 34 is arranged inside the mounting hole 33. The two ends of the quartz oscillator 34 are connected to the wiring patterns 32 through terminals 35, respectively. The quartz oscillator 34 and the terminals 35 are secured to each other by use of solder 36. Notches 37 are formed in each terminal 35 such that the width of each connection portion 38 is reduced.

When the IC card is used or carried, it may be curved or its temperature may increase. In such a case, the printed circuit board 31 of the IC card is deformed in such a manner as is illustrated in Fig. 8. However, each terminal 35 is provided with notches 37, and each connection portion 38 is narrowed, accordingly. Therefore, when the printed circuit board 31 is deformed, the connection portions 38 are deformed, thus absorbing the stress. Accordingly, the large stress is not transmitted to the terminals 35. This being so, the quartz oscillator 34 is reliably prevented from being disconnected from the terminals 35 and from being broken or damaged.

## Claims

1. An IC card incorporating an electronic component, comprising:
   a printed circuit substrate (11, 31), having a cavity for receiving the electronic component (19, 34) installed therein
   characterized by further comprising:
   a terminal means (27, 35), projected into the cavity (25, 33) for connecting the electronic component (19, 34) and the printed circuit substrate (11, 31).

2. An IC card according to claim 1, characterized in that said printed circuit substrate (11, 31) includes a space (29) defined between one face of the terminal (27, 35) and the circumference of the cavity (25, 33).

3. An IC card according to claim 1, characterized in that said electronic component (19) includes a quarts oscillator (19).

4. An IC card according to claim 3, characterized in that said terminal means (27, 35) includes a connecting portion for connecting the terminal means (35) and the quartz oscillator (19) by a solder (28).

5. An IC card according to claim 1, characterized in that said a notch (37) is formed between the terminal (35) and the printed circuit substrate (11, 31).

6. An IC card according to claim 5, characterized in that said electronic component (34) includes a quarts oscillator (34).

7. An IC card according to claim 6, characterized in that said terminal means (27, 35) includes a connecting portion for connecting the terminal means (35) and said quartz oscillator (34) by a solder (36).

8. An IC card according to claim 1, characterized in that said terminal means (27, 35) includes a member which is more Hexible than said substrate (11, 31).

9. A circuit board incorporating an electronic component, comprising:
substrate means (11, 31) for incorporating the electronic component (19,34) is installed;
characterized by comprising:
supporting means (27, 35) projected from the substrate means (11, 31), for supporting the electronic component (19, 34) there on; and
connecting means (28, 36) for connecting the supporting means (27, 35) and the electronic component (19, 34).

10. A circuit board according to claim 9, characterized in that the supporting means (27, 35) includes;
first projection (27, 35) formed on the substrate means (11, 31) for projecting along to one end of the electronic component (19, 34); and
second projection means (27, 35) formed on the substrate means (11, 31) for projecting along to another end of the electronic component (19, 35).

11. A circuit board according to claim 10, characterized in that the connecting means (28, 36) includes;
first connections means (28, 36) for connecting the first projection means (27, 35) to one end of the electronic components (19, 34); and
second connecting means (28, 36) for connecting the second projection means (27, 35) to the another end of the electronic component (19, 34).

12. A circuit board according to claim 9, characterized in that said substrate means (11, 31) has an opening (25, 33) for receiving the electronic component (19, 34).

13. A circuit board according to claim 12, characterized in that said opening (25, 33) of the substrate (11, 13) and electronic component (19, 34) have a quadrilateral form.

14. A circuit board according to claim 13, characterized in that said projection means (21, 35) projects in parallel to a side of the quadrilateral electronic components (19, 34).

15. A circuit board according to claim 10, characterized in that said substrate means (11, 31) and said projection means (27, 35) are formed by a flexible plate.

103    101

102    102

F I G.    1

2

5

3

1

| SAVE ACCT | O Z 1 | ABC 2 | DEF 3 | NO · | NEXT + |
| CARD | CORP CARD | GHI 4 | JKL 5 | MNO 6 | YES = | BACK − |
| CHECK ACCT | 0 | PRS 7 | TUV 8 | WXY 9 | × | ÷ |

4

F I G.    2

F I G.  3

F I G. 4

F I G. 5

F I G. 6

F I G. 7

F I G. 8